# EUROPEAN PATENT SPECIFICATION

(11) **EP 4 047 024 B1**
(45) Date of publication and mention of the grant of the patent: **10.07.2024**
(21) Application number: 20877174.1
(22) Date of filing: 18.09.2020
(51) Int. Cl.: H01L 23/29, H01L 23/31, C09J 135/02, C08F 2/44, C08F 122/14, C09J 4/00, C08F 222/14, C08F 2/38

(54) **POLYMERIZABLE COMPOSITION AND CURABLE RESIN COMPOSITION USING SAME**
POLYMERISIERBARE ZUSAMMENSETZUNG UND HÄRTBARE HARZZUSAMMENSETZUNG DAMIT
COMPOSITION POLYMÉRISABLE ET COMPOSITION DE RÉSINE DURCISSABLE L'UTILISANT

(30) Priority: 18.10.2019 JP 2019190969
(43) Date of publication of application: 24.08.2022
(73) Proprietor: Namics Corporation, Niigata-shi, Niigata 950-3131 (JP)
(72) Inventor: SATO Ayako, Niigata-shi, Niigata 950-3131 (JP)
(74) Representative: Hoffmann Eitle
(86) International application number: PCT/JP2020/035450
(87) International publication number: WO 2021/075206

(56) References cited:
- WO-A1-2018/212330
- JP-A- 2018 517 809
- JP-A- 2019 081 879
- JP-A- 2019 516 668
- US-A1- 2011 300 482
- US-A1- 2015 210 894
- US-A1- 2017 204 524
- US-A1- 2019 270 117

## Description

### TECHNICAL FIELD

The present invention relates to a polymerizable composition and a curable resin composition using the same.

### BACKGROUND ART

In recent years, in the production of electronic components, it has been investigated to use, as an adhesive or the like, a curable resin composition comprising a 2-methylene-1,3-dicarbonyl compound, such as a methylene malonate. Such a curable resin composition cures in a short time even at a low temperature, such as room temperature, and is useful for avoiding adverse effects due to heat for curing and improving production efficiency.

Methylene malonate has been known for a long time. In fact, the report on diethyl methylene malonate, the first reported methylene malonate, has been made by W. H. Perkin, Jr. in 1886. However, it has been difficult for a long time to supply a methylene malonate on a commercial scale, despite its interesting characteristics. One of the reasons for this difficulty was difficulty in suppression of production of by-products during the producing process. Due to these by-products, a methylene malonate may be unexpectedly polymerized, or conversely, the above-mentioned rapid polymerization may be inhibited. It has been known that this inhibition of polymerization is caused by an acid generated from a by-product, such as a ketal (Patent Document 1).

At present, improvement in producing technology (Patent Document 1) has made a methylene malonate commercially available. WO 2018/212330A1 (Patent document 2) discloses a resin composition comprising one or more 2-methylene 1,3-dicarbonyl compounds, wherein at least one of the one or more 2-methylene 1,3-dicarbonyl compounds has a molecular weight of 220 to 10000 and triethylamine. It also discloses a cured product obtained by curing the resin composition, an adhesive or sealing material comprising the resin composition and a semiconductor device comprising the cured product.

### PRIOR ART DOCUMENTS

### Patent Documents

Patent Document 1: WO 2014/110388, Patent Document 2: WO 2018/212330A1

### Non-Patent Documents

Non-Patent Document 1: Journal of Synthetic Organic Chemistry, Japan, 1975, vol. 33, No. 11, pp. 915-924
Non-Patent Document 2: Perkin, Ber. 19, 1053 (1886)

### SUMMARY OF THE INVENTION

### Problems To Be Solved By the Invention

The above-mentioned technological improvements have been done, but it is not difficult to imagine that it is still difficult to strictly control the contents of all impurities to a very minute amount.

These impurities may have, depending on the types thereof, a serious effect on polymerizability of a 2-methylene-1,3-dicarbonyl compound, even when they are present in minute amounts. Incidentally, a reaction rate of anionic polymerization is susceptible to impurities (Non-Patent Document 1). Further, a stabilizer, which may be added to a polymerizable composition, may make impossible to obtain satisfactory curing rate.

Therefore, it is desirable to apply some treatment to the 2-methylene-1,3-dicarbonyl compound to ensure an excellent curing rate. However, such a treatment is essentially a treatment for promoting anionic polymerization which may cause lowering of storage stability (increase in possibility of unexpected polymerization) of the 2-methylene-1,3-dicarbonyl compound and, in that case, industrial applicability is disadvantageously limited.

It is an object of the present invention is to provide a polymerizable composition comprising a 2-methylene-1,3-dicarbonyl compound, the composition being capable of simultaneously realizing an excellent curing rate and excellent storage stability, in order to solve the above-mentioned prior art problems.

### MEANS TO SOLVE THE PROBLEM

As a result of intensive research to solve the above-mentioned problems, the present inventor has arrived at the present invention.

That is, the present invention includes, but is not limited to, the following inventions.
1. A polymerizable composition comprising:
   (a) at least one 2-methylene-1,3-dicarbonyl compound each having at least one structural unit represented by formula (I) below: 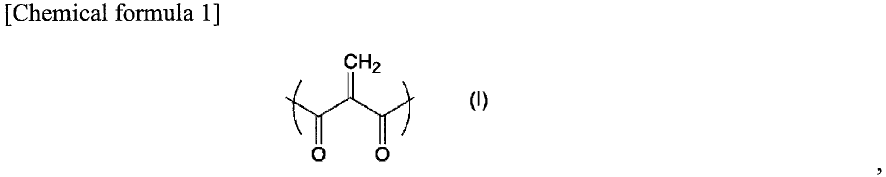 and
   (b) at least one ionic compound which does not substantially react with the compound (a), the ionic compound comprising:
      an anion selected from the group consisting of a bissulfonylimide anion, hexafluorophosphate anion and a sulfonate anion; and
      an onium cation, and
      which polymerizable composition polymerizes when contacted with a polymerization initiator comprising at least one basic substance.
2. The polymerizable composition according to item 1 above, wherein the onium cation of the ionic compound (b) is at least one member selected from the group consisting of an ammonium cation, a phosphonium cation and a sulfonium cation.
3. The polymerizable composition according to item 1 or 2 above, wherein the molecular weight of the 2-methylene-1,3-dicarbonyl compound is 180 or more and 10,000 or less.
4. The polymerizable composition according to any one of items 1 to 3 above, which comprises 250 ppm to 10,000 ppm of water.
5. A one-part curable resin composition which comprises the polymerizable composition according to any one of items 1 to 4 above and a polymerization initiator comprising at least one basic substance which is rendered latent.
6. The one-part curable resin composition according to item 5 above, which comprises 250 ppm to 10,000 ppm of water.
7. A kit of a two-part mixing curable resin composition, which comprises:
   (A) a base resin comprising the polymerizable composition according to any one of items 1 to 4 above; and
   (B) a curing agent comprising the following (c):
      (c) a polymerization initiator comprising at least one basic substance.
8. The polymerizable composition according to any one of items 1 to 4 above, the one-part curable resin composition according to item 5 or 6 above or the kit according to item 7 above, which is used for production of electronic components.
9. An adhesive or sealing material for electronic components, which comprises the polymerizable composition according to any one of items 1 to 4 above, the one-part curable resin composition according to item 5 or 6 above, or the kit according to item 7 above.
10. A cured product obtained by curing the polymerizable composition according to any one of items 1 to 4 above, the one-part curable resin composition according to item 5 or 6 above, the kit according to item 7 above, or the adhesive or sealing material according to item 9 above.
11. A semiconductor device which comprises the cured product according to item 10 above.

The polymerizable composition of the present invention comprises a 2-methylene-1,3-dicarbonyl compound and a specific ionic compound. The polymerizable composition of the present invention has excellent storage stability, and the gel time of the composition after the addition of a polymerization initiator is shortened, as compared with the gel time of the above-mentioned 2-methylene-1,3-dicarbonyl compound after the addition of the polymerization initiator in the absence of the above-mentioned ionic compound. Therefore, a curable resin composition can be easily produced the using the polymerizable composition of the present invention, since the curing reaction can be promoted without impairing storage stability.

### DESCRIPTION OF EMBODIMENTS

Hereinafter, embodiments of the present invention are described in detail.

The present invention relates to a polymerizable composition. This composition comprises:
(a) at least one 2-methylene-1,3-dicarbonyl compound (hereinafter may be referred to as "Component (a)"); and
(b) at least one specific ionic compound (hereinafter may be referred to as "Component (b)").

Hereinafter, the components contained in the polymerizable composition of the present invention are explained.

### [(a) 2-Methylene-1,3-dicarbonyl compound (Component (a))]

The polymerizable composition of the present invention comprises a 2-methylene-1,3-dicarbonyl compound (Component (a)). In the present invention, the 2-methylene-1,3-dicarbonyl compound is a compound having at least one structural unit represented by formula (I) below:

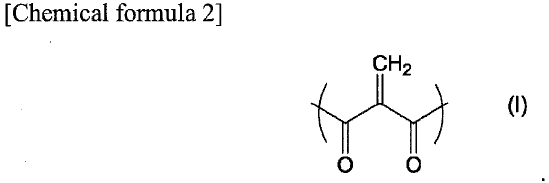

Component (a) comprises one or two or more structural units of formula (I) above. In some embodiments, Component (a) comprises two to six, preferably two structural unit of formula (1) above.

The structural unit of formula (1) above is composed of a vinyl group with one π-bond carbon having covalently bonded thereto two carbonyl groups and another π-bond carbon having covalently bonded thereto no substituent. In such a structure, due to the influence of the above-mentioned carbonyl groups, the above-mentioned π-bonded carbon in the above-mentioned vinyl group having covalently bonded thereto no substituent is susceptible to nucleophile attack (that is, the above-mentioned vinyl group is activated). This brings high polymerizability to Component (a).

The 2-methylene-1,3-dicarbonyl compound can be used as Component (a) in the present invention, because it comprises the structural unit of formula (I) above and these structural units polymerize with each other in the presence of a polymerization initiator, typically a basic substance (the polymerization initiator (Component (c)) described later). If the above-mentioned 2-methylene-1,3-dicarbonyl compounds comprise 2-methylene-1,3-dicarbonyl compounds that comprise two or more structural units of formula (I) above (multifunctional components), cross-links are formed during curing, and this is expected to result in improvement in physical properties of the cured product such as enhanced mechanical properties at high temperatures.

Component (a) comprises at least one 2-methylene-1,3-dicarbonyl compound. The 2-methylene-1,3-dicarbonyl compound contained in Component (a) preferably has a molecular weight of 180 to 10,000, more preferably 180 to 5,000, even more preferably 180 to 2,000, even more preferably 220 to 2,000, even more preferably 220 to 1,500, even more preferably 240 to 1,500, particularly preferably 250 to 1,500, and most preferably 250 to 1,000. The molecular weight of the 2-methylene-1,3-dicarbonyl compound contained in Component (a), and the amount by mass of each 2-methylene-1,3-dicarbonyl compound contained relative to the entire composition (or the totality of the 2-methylene-1,3-dicarbonyl compounds in the composition) of 1, can be determined, for example, by quantification by means of reversed phase high performance liquid chromatography (reversed phase HPLC) using an ODS column as the column and, as the detector, a mass spectrometer (MS) with PDA (detection wavelength: 190 nm to 800 nm) or ELSD. If the molecular weight of Component (a) is less than 180, the vapor pressure at 25 °C may be excessively high, and this may cause various problems arising from volatiles. In particular, volatiles will, on adhering to members in their vicinity, be cured by bases on the surface, leading to contamination of the members in their vicinity. On the other hand, if the molecular weight of Component (a) exceeds 10,000, it results in the viscosity of the composition becoming high, which decreases workability and also causes other issues such as imposing limitations on the amount of fillers that can be added.

Component (a) may comprise a multifunctional component. The term multifunctional herein means that the 2-methylene-1,3-dicarbonyl compound comprises two or more structural units of formula (I) above. The number of the structural units of formula (I) above contained in the 2-methylene-1,3-dicarbonyl compound is referred to as the "number of functional groups" of the 2-methylene-1,3-dicarbonyl compound. Among the 2-methylene-1,3-dicarbonyl compounds, those for which the number of functional groups is one are referred to as "monofunctional", those for which the number of functional groups is two are referred to as "bifunctional", and those for which the number of functional groups is three are referred to as "trifunctional". Since a cured product obtained using Component (a) that comprises a multifunctional component is cross-linked, the cured product has improved physical properties, such as heat resistance and mechanical properties at high temperatures. When a multifunctional component is used, the ratio by mass of the multifunctional component is preferably 0.01 or greater relative to the entire polymerizable composition of the present invention of 1. In an embodiment, the ratio by mass of those of Component (a) that comprise two or more structural units represented by formula (I) above is preferably 0.01 to 1.00, more preferably 0.05 to 0.99, even more preferably 0.05 to 0.95, particularly preferably 0.10 to 0.90, most preferably 0.10 to 0.80, relative to the entire polymerizable composition of the present invention of 1.

If Component (a) comprises a multifunctional component, a network-like cross-linked structure is formed in the cured product, with the result that the cured product does not flow and maintains a constant storage modulus even at high temperatures, in particular, at temperatures equal to or higher than its glass transition temperature. The storage modulus of the cured product at high temperatures can be measured, for example, by dynamic mechanical analysis (DMA). In general, if a cured product having a cross-linked structure formed therein is evaluated by DMA, a region known as a plateau, the region where changes in storage modulus are relatively small as the temperature changes, is observed over a wide temperature range above its glass transition temperature. The storage modulus in this plateau region is evaluated as a quantity related to crosslink density, i.e., the proportion of the multifunctional component in Component (a).

In an embodiment, the ratio by mass of Component (a) is preferably 0.05 to 1.00, more preferably 0.10 to 0.99, even more preferably 0.20 to 0.99, and particularly preferably 0.50 to 0.99, relative to the entire polymerizable composition of the present invention of 1.

In an embodiment, the 2-methylene-1,3-dicarbonyl compound is represented by formula (II) below: 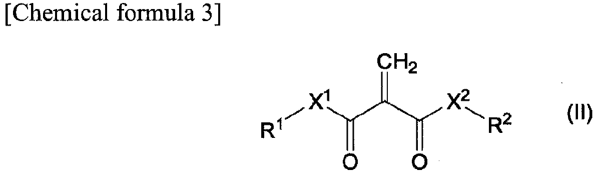 (wherein:
X¹ and X² each independently represent a single bond, O or NR³, wherein R³ represents hydrogen or a monovalent hydrocarbon group,
R¹ and R² are each independently hydrogen, a monovalent hydrocarbon group, or represented by formula (III) below: 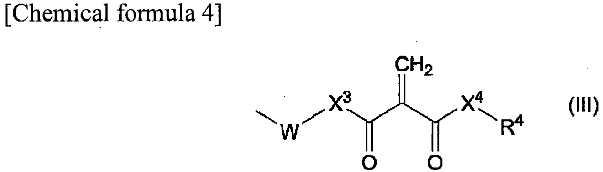
(wherein:
   X³ and X⁴ each independently represent a single bond, O or NR⁵, wherein R⁵ represents hydrogen or a monovalent hydrocarbon group,
   W represents a spacer, and
   R⁴ represents hydrogen or a monovalent hydrocarbon group)).

In an embodiment, the 2-methylene-1,3-dicarbonyl compound is represented by formula (IV) below: 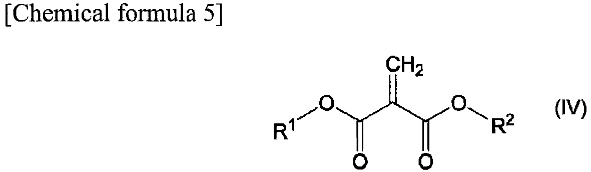 (wherein:
R¹ and R² are each independently hydrogen, a monovalent hydrocarbon group, or represented by formula (V) below: 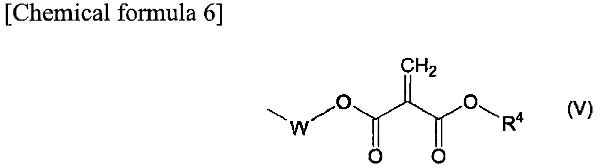
(wherein:
   W represents a spacer, and
   R⁴ represents hydrogen or a monovalent hydrocarbon group)).

In another embodiment, the 2-methylene-1,3-dicarbonyl compound is a dicarbonylethylene derivative represented by formula (VI) below: 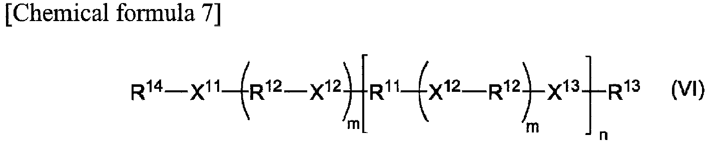 (wherein:
R¹¹ represents a 1,1-dicarbonylethylene unit represented by formula (VII) below: 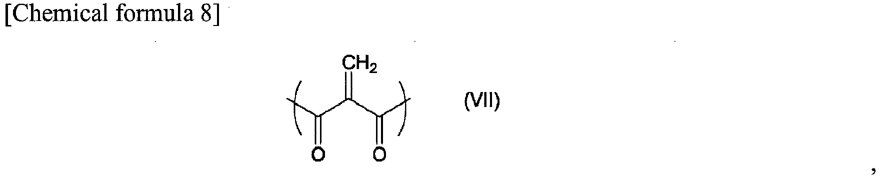
each R¹² each independently represents a spacer,
R¹³ and R¹⁴ each independently represent hydrogen or a monovalent hydrocarbon group,
X¹¹ and each X¹² and X¹³ each independently represent a single bond, O or NR¹⁵, wherein R¹⁵ represents hydrogen or a monovalent hydrocarbon group,
each m each independently represents 0 or 1, and
n represents an integer of 1 or more and 20 or less).

As used herein, the term monovalent hydrocarbon group refers to a group generated by removing one hydrogen atom from a carbon atom of a hydrocarbon. As examples of the monovalent hydrocarbon group, there can be mentioned an alkyl group, an alkenyl group, an alkynyl group, a cycloalkyl group, an alkyl-substituted cycloalkyl group, an aryl group, an aralkyl group, and an alkaryl group, and a portion of each of these groups may contain a heteroatom, such as N, O, S, P and Si. The monovalent hydrocarbon group with a portion thereof containing a heteroatom may have, for example, a polyether structure or a polyester structure.

Each of the above-mentioned monovalent hydrocarbon groups may be substituted with alkyl, cycloalkyl, heterocyclyl, aryl, heteroaryl, allyl, alkoxy, alkylthio, hydroxyl, nitro, amide, azide, cyano, acyloxy, carboxy, sulfoxy, acryloxy, siloxy, epoxy or ester.

The above-mentioned monovalent hydrocarbon group is preferably an alkyl group, a cycloalkyl group, an aryl group or an alkyl group substituted by a cycloalkyl group, more preferably an alkyl group, a cycloalkyl group or an alkyl group substituted by a cycloalkyl group.

There is no particular limitation with respect to the number of the carbons in the above-mentioned alkyl group, alkenyl group and alkynyl group (hereinafter collectively referred to as the "alkyl group etc."). The number of the carbons in the above-mentioned alkyl group is usually 1 to 18, preferably 1 to 16, more preferably 2 to 12, even more preferably 3 to 10, and particularly preferably 4 to 8. The number of the carbons in the above-mentioned alkenyl group and alkynyl group is usually 2 to 12, preferably 2 to 10, more preferably 3 to 8, even more preferably 3 to 7, and particularly preferably 3 to 6. If the above-mentioned alkyl group etc. have a cyclic structure, the number of carbon atoms in the alkyl group etc. is usually 5 to 16, preferably 5 to 14, more preferably 6 to 12, even more preferably 6 to 10. The number of the carbons in the above-mentioned alkyl group etc. can be identified by, for example, reversed phase HPLC described above or nuclear magnetic resonance technique (NMR technique).

There is no particular limitation with respect to the structure of the alkyl group etc. The above-mentioned alkyl group etc. may be linear or may have a side chain. The above-mentioned alkyl group etc. may be a chain structure or may be a cyclic structure (a cycloalkyl group, a cycloalkenyl group and a cycloalkynyl group). The above-mentioned alkyl group etc. may have one or two or more other substituents. For example, the above-mentioned alkyl group etc. may have a substituent comprising an atom other than a carbon atom or a hydrogen atom as a substituent. Also, the above-mentioned alkyl group etc. may comprise one or two or more atoms other than a carbon atom or a hydrogen atom in a chain structure or a cyclic structure. As examples of the above-mentioned atoms other than carbon atoms and hydrogen atoms, there can be mentioned one or two or more of an oxygen atom, a nitrogen atom, a sulfur atom, a phosphorus atom and a silicon atom.

As specific examples of the above-mentioned alkyl group, there can be mentioned a methyl group, an ethyl group, an n-propyl group, an i-propyl group, an n-butyl group, an i-butyl group, a sec-butyl group, a t-butyl group, a pentyl group, an isopentyl group, a neopentyl group, a hexyl group, a heptyl group, an octyl group, and a 2-ethylhexyl group. As specific examples of the above-mentioned cycloalkyl group, there can be mentioned a cyclopentyl group, a cyclohexyl group, a cycloheptyl group, and a 2-methylcyclohexyl group. As examples of the above-mentioned alkenyl group, there can be mentioned a vinyl group, an allyl group, and an isopropenyl group. As specific examples of the above-mentioned cycloalkenyl group, there can be mentioned a cyclohexenyl group.

When the 2-methylene-1,3-dicarbonyl compound is represented by formula (II) or (IV) above and R¹ and R² are both monovalent hydrocarbon groups, it is particularly preferable that R¹ and R² are each an alkyl group, a cycloalkyl group, an alkyl-substituted cycloalkyl group, an aryl group, an aralkyl group or an alkaryl groups having 2 to 8 carbons.

As used herein, the term spacer refers to a divalent hydrocarbon group, more specifically a cyclic, linear or branched, substituted or unsubstituted alkylene group. There is no particular limitation with respect to the number of the carbon atoms in the above-mentioned alkylene group. The number of the carbon atoms in the above-mentioned alkylene group is usually 1 to 12, preferably 2 to 10, more preferably 3 to 8, and still more preferably 4 to 8. If desired, the above-mentioned alkylene group may comprise, in the middle thereof, a group comprising a heteroatom selected from N, O, S, P, and Si. The above-mentioned alkylene group may have an unsaturated bond. In an embodiment, the spacer is an unsubstituted alkylene group having 4 to 8 carbon atoms. Preferably, the spacer is a linear, substituted or unsubstituted alkylene group, more preferably an alkylene group having a structure represented by the formula -(CH₂)ₙ- (wherein n is an integer of 2 to 10, preferably 4 to 8) with the carbon atoms at the both ends thereof being bonded to the remaining portion of the 2-methylene-1,3-dicarbonyl compound.

Specific examples of the divalent hydrocarbon group as the above-mentioned spacer include, but are not limited to, a 1,4-n-butylene group and a 1,4-cyclohexylene dimethylene group.

When the 2-methylene-1,3-dicarbonyl compound has a spacer, the number of carbons in the terminal monovalent hydrocarbon group is preferably 6 or less. That is, when the 2-methylene-1,3-dicarbonyl compound is represented by formula (II) or (IV) above, it is preferred that R⁴ in formula (III) or (V) above is an alkyl group having 1 to 6 carbon atoms, but when either one of R¹ and R² is represented by formula (III) or formula (V) above, it is preferred that the other of R¹ and R² is an alkyl group having 1 to 6 carbon atoms. In this case, in formula (II) or formula (IV) above, both of R¹ and R² may be represented by formula (III) or formula (V) above, and preferably, only one of R¹ and R² is represented by formula (III) or formula (V) above. Preferably, the 2-methylene-1,3-dicarbonyl compound is represented by formula (IV) above.

As examples of particularly preferable compounds having a spacer, there can be mentioned a compound represented by formula (IV) above, wherein one of R¹ and R² is any one of an ethyl group, an n-hexyl group or a cyclohexyl group, the other is represented by formula (V) above, W is either a 1,4-n-butylene group or a 1,4-cyclohexylene dimethylene group and R⁴ is any one of an ethyl group, an n-hexyl group or a cyclohexyl group. As examples of other particularly preferable compound, there can be mentioned a compound represented by formula (IV) above, wherein R¹ and R² are represented by formula (V) above, W is either a 1,4-n-butylene group or a 1,4-cyclohexylene dimethylene group and R⁴ is any one of an ethyl group, an n-hexyl group or a cyclohexyl group.

A variety of 2-methylene-1,3-dicarbonyl compounds are available from Sirrus Inc., Ohio, USA, and synthetic methods thereof are disclosed in publications of patent applications such as WO2012/054616, WO2012/054633 and WO2016/040261. If both ends of the structural unit represented by formula (I) above contained in the 2-methylene-1,3-dicarbonyl compound are bonded to oxygen atoms, 2-methylene-1,3-dicarbonyl compounds having a higher molecular weight in which a plurality of structural units represented by formula (I) above are liked via an ester bond and the above-mentioned spacer can be produced by using methods known in the art, such as the transesterification with a diol or polyol disclosed in Japanese Translation of PCT International Application Publication No. JP-T-2015-518503. The 2-methylene-1,3-dicarbonyl compound thus prepared may comprise a hydroxy group in R¹ and R² in formula (II) or formula (IV) above, R⁴ in formula (III) or formula (V) above, and R¹⁴ and R¹³ in formula (VI) above. Component (a), which comprises 2-methylene-1,3-dicarbonyl compounds, can be obtained, as appropriate, by combining these 2-methylene-1,3-dicarbonyl compounds. Especially, the multifunctional component (that is, the 2-methylene-1,3-dicarbonyl compound having two or more structural units of formula (I) above) can be synthesized by, for example, the method as disclosed in JP 2015-517973A.

As specific examples of the 2-methylene-1,3-dicarbonyl compound preferable as Component (a), there can be mentioned dibutyl methylene malonate, dipentyl methylene malonate, dihexyl methylene malonate, dicyclohexyl methylene malonate, ethyl octyl methylene malonate, propyl hexyl methylene malonate, 2-ethylhexyl ethyl methylene malonate, ethylphenyl ethyl methylene malonate and the like. These are preferable because of their low volatility and high reactivity. From the perspective of handleability, dihexyl methylene malonate and dicyclohexyl methylene malonate are particularly preferable.

### [(b) Ionic compound (Component (b))]

The polymerizable composition of the present invention comprises at least one ionic compound (Component (b)). Component (b) comprises:
an anion selected from the group consisting of a bissulfonylimide anion, hexafluorophosphate anion and a sulfonate anion; and
an onium cation.

Component (b) does not essentially have an effect as a polymerization initiator of the above-mentioned Component (a), so that Component (b) does not substantially react with Component (a). Component (b) "does not substantially react" with Component (a) means that when these components are in contact with each other, the gel time is more than 1 day, preferably more than 10 days, more preferably more than 30 days, further more preferably more than 90 days, and particularly preferably more than 150 days.

As used herein, unless otherwise specified, the gel time of a certain polymerizable (or curable) compound or composition refers to the period measured at room temperature (22 °C) from the point of time of preparation with respect to the compound or composition (or a mixture of that with a polymerization initiator) to the point of time of practical loss of its fluidity. When the fluidity is not lost within a certain period, the gel time is expressed as being more than that period.

Therefore, a mixture of Component (b) and Component (a), that is, the polymerizable composition of the present invention, has high storage stability and does not cure for a long period of time.

However, the polymerizable composition of the present invention polymerizes when it is contacted with a polymerization initiator described later. In this situation, the polymerizable composition of the present invention cures faster than Component (a) containing no Component (b). More specifically, the ratio of the gel time for the polymerizable composition of the present invention to which the polymerization initiator is added, relative to the gel time for Component (a) containing no Component (b) to which the polymerization initiator is added, is usually 0.90 or less, preferably 0.75 or less, more preferably 0.60 or less. That is, Component (b) has an effect of promoting polymerization of Component (a).

In the present invention, a composition is "polymerizable" means that at least a part of the activated vinyl groups of Component (a) contained in the composition remains unreacted to the extent that the fluidity of the composition is not lost and the fluidity is lost by polymerization of Component (a) when the composition is contacted with an appropriate polymerization initiator.

The polymerizable composition of the present invention "polymerizes when it is contacted with a polymerization initiator" means that polymerization of Component (a) does not substantially proceed (or proceeds only at extremely low late) prior to the contact of the polymerizable composition of the present invention with the polymerization initiator, but rapidly proceeds after the contact of the polymerizable composition of the present invention with the polymerization initiator.

Storage stability of Component (a) (for example, a methylene malonate) is affected by impurities, such as acids, present due to generation or contamination during production, and/or acids added for the purpose of improving storage stability (Patent Document 1 and the like). When a curable resin composition is produced using such Component (a) as it is, various characteristics of the obtained composition are affected, and especially the gel time may become long.

In the polymerizable composition of the present invention, as mentioned above, the gel time of the curable resin composition can be shortened by the effect of Component (b). Accordingly, when the polymerizable composition of the present invention is used, it is possible to easily produce a curable resin composition capable of promoting the curing reaction without impairing storage stability. It was found out first by the present inventors that Component (b) had the above-mentioned effect.

In the present invention, the anion contained in Component (b) is not particularly limited as long as the anion has the above-mentioned effect. In an embodiment, the anion is selected from the group consisting of a bissulfonylimide anion, hexafluorophosphate anion and a sulfonate anion. Conversely, when the anion of Component (b) is a carboxylate anion or a phosphate anion (including a partially esterified one), for example, the ionic compound (salt) containing the anion above cannot be used as Component (b), since the anion above has nucleophilicity sufficient for nucleophilically attacking Component (a). Further, an ionic compound (salt) containing a halide ion is not suitable as Component (b) especially when the curable resin composition produced using the polymerizable composition of the present invention is intended to be used for electronic material uses. This is because a substance containing a halogen atom may corrode metal parts. In an embodiment, Component (b) does not contain a halide ion.

Preferably, each of the two sulfonic acid residues contained in the bissulfonylimide anion, one option of the anion in Component (b), is independently derived from at least one member selected from the group consisting of an alkylsulfonic acid having 1 to 10 carbon atoms with hydrogen atoms which may be partially or completely fluorinated, an arylsulfonic acid having 6 to 10 carbon atoms with hydrogen atoms which may be partially or completely fluorinated, an aralkylsulfonic acid having 6 to 10 carbon atoms with hydrogen atoms which may be partially or completely fluorinated, and an alkarylsulfonic acid having 6 to 10 carbon atoms with hydrogen atoms which may be partially or completely fluorinated. More preferably, each of the above-mentioned sulfonic acid residues is derived from an alkylsulfonic acid having 1 to 10 carbon atoms with hydrogen atoms which may be partially or completely fluorinated. Especially preferably, each of the above-mentioned sulfonic acid residues is derived from trifluoromethanesulfonic acid.

Preferably, the sulfonate anion, one option of the anion in Component (b), is derived from one member selected from the group consisting of an alkylsulfonic acid having 1 to 10 carbon atoms with hydrogen atoms which may be partially or completely fluorinated, an arylsulfonic acid having 6 to 10 carbon atoms with hydrogen atoms which may be partially or completely fluorinated, an aralkylsulfonic acid having 6 to 10 carbon atoms with hydrogen atoms which may be partially or completely fluorinated, and an alkarylsulfonic acid having 6 to 10 carbon atoms with hydrogen atoms which may be partially or completely fluorinated. Especially preferably, the sulfonate anion is derived from trifluoromethanesulfonic acid.

Especially preferably, from the viewpoint of storage stability, the anion contained in Component (b) is a bissulfonylimide anion and/or hexafluorophosphate anion.

As used herein, in general, an onium cation means a cation generated by coordinating, in a compound containing an atom having a lone pair of electrons, a hydrogen ion or a cationic group of atoms to the lone pair of electrons. Typical onium cations are an ammonium cation, a phosphonium cation, a sulfonium cation, an oxonium cation and the like. Further, a cation derived from a compound containing an atom with a lone pair of electrons forming a multiple bond (for example, a double bond), such as a pyridinium cation, an imidazolium cation and the like, are included in the onium cation, since such a cation also meets the above-mentioned definition.

The onium cation of Component (b) is preferably at least one member selected from the group consisting of a quaternary ammonium cation, a quaternary phosphonium cation and a tertiary sulfonium cation, more preferably a quaternary ammonium cation and/or a quaternary phosphonium cation, particularly preferably a quaternary ammonium cation.

As examples of the quaternary ammonium cation, quaternary phosphonium cation and tertiary sulfonium cation, there can be mentioned the onium cations respectively represented by the following formulae: 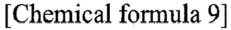 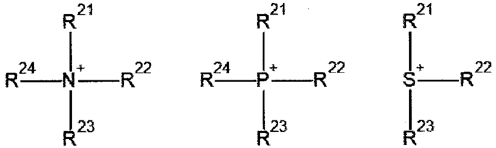 (wherein:
each of R²¹ to R²⁴ independently represents an unsubstituted or substituted hydrocarbon group having 1 to 40 carbon atoms, preferably 1 to 20 carbon atoms, and more preferably 1 to 12 carbon atoms (a portion of the carbon atoms contained therein may be replaced with a heteroatom selected from the group consisting of an oxygen atom, a nitrogen atom and a sulfur atom), and
two or more of R²¹ to R²⁴, together with a nitrogen atom, a phosphorus atom or a sulfur atom to which they are bonded, may be bonded to each other to form a saturated or partially unsaturated alicyclic ring or an aromatic ring).

When two or more of R²¹ to R²⁴ in the above-mentioned formula, together with a nitrogen atom, a phosphorus atom or a sulfur atom to which they are bonded, are bonded to each other to form a ring, the above-mentioned onium cation is a cyclic onium cation. As examples of such a cyclic onium cation, there can be mentioned an unsubstituted or substituted pyrrolidinium cation, an unsubstituted or substituted morpholinium cation, an unsubstituted or substituted pyridinium cation, an unsubstituted or substituted imidazolium cation and the like.

When Component (b) contains a heteroaromatic ring, such as that in an unsubstituted or substituted pyridinium cation, an unsubstituted or substituted imidazolium cation and the like, minute attention must be paid to avoid contamination with the starting materials and/or by-products of the heteroaromatic ring as impurities. This is to avoid unintended initiation of polymerization of Component (a) by highly reactive impurities. Therefore, in the above-mentioned quaternary ammonium cation, it is preferred that N⁺ and each of R²¹ to R²⁴ in the above-mentioned formula representing the quaternary ammonium cation are bonded through a single bond. In an embodiment, Component (b) does not contain an onium cation having a heteroaromatic ring, such as imidazolium or the like.

High affinity (compatibility) of Component (b) for Component (a) is not necessary and, even when Component (a) and Component (b) provide a heterogeneous mixture, the above-mentioned effects can be obtained. In an embodiment, the polymerizable composition of the present invention is homogeneous. In another embodiment, the polymerizable composition of the present invention is heterogeneous.

In the present invention, the content of Component (b) based on the total weight (100 wt%) of Component (a) and Component (b) is 0.01 wt% or more and less than 20 wt%, preferably 0.05 wt% or more and less than 10 wt%, more preferably 0.1 wt% or more and less than 5 wt%, further preferably 0.2 wt% or more and less than 2 wt%. When the content of Component (b) is 20 wt% or more, bleeding may occur and/or curing may be insufficient. In this case, there is a concern of occurrence of unintended polymerization reaction, such as that caused by impurities contained in Component (b). Conversely, when the content of Component (b) is less than 0.01 wt%, the above-mentioned effect of improving the coexisting polymerization initiator or promoting polymerization of Component (a) becomes insufficient.

### [Other components]

The polymerizable composition of the present invention may further comprise a stabilizer.

The stabilizer is a substance for enhancing the stability of the composition at the time of storage, and is added to suppress the occurrence of unintended polymerization reactions due to radicals or basic components. Component (a) may undergo unintended radical polymerization reactions triggered by radicals that are accidentally generated. Also, Component (a) may undergo anionic polymerization reactions due to contamination by extremely small amounts of basic components. The occurrence of such unintended polymerization reactions due to radicals or basic components can be suppressed by adding a stabilizer.

Stabilizers known in the art can be used as the stabilizer and, for example, a strong acid or a radical scavenger can be used. As specific examples of stabilizers, there can be mentioned trifluoromethanesulfonic acid, maleic acid, methanesulfonic acid, difluoroacetic acid, trifluoroacetic acid, trichloroacetic acid, phosphoric acid, dichloroacetic acid, N-nitroso-N-phenylhydroxylamine aluminum, triphenylphosphine, 4-methoxyphenol, and hydroquinone. Among these, a preferable stabilizer(s) is/are at least one member selected from maleic acid, methanesulfonic acid, N-nitroso-N-phenylhydroxylamine aluminum and 4-methoxyphenol. Stabilizers known in the art, such as those disclosed in JP 2010-117545 A and JP 2008-184514 A, can also be used as the stabilizer.

The stabilizer may be used individually or in combination.

The polymerizable composition of the present invention may comprise, in addition to each of the above-mentioned components, an insulating or conductive filler, a surface treatment agent such as a coupling agent, a pigment, a plasticizer and the like, if necessary.

In an embodiment, the polymerizable composition of the present invention further comprises water. The storage stability of the polymerizable composition is not deteriorated by the water contained in the polymerizable composition. In another embodiments, the one-part curable resin composition of the present invention further comprises water. In a certain aspect, the gel time of the one-part curable resin composition can be further shortened by the water contained in the curable resin, and even in this case, the storage stability can be maintained.

When the polymerizable composition of the present invention comprises water, the water may be added or absorbed from water in the air. When the polymerizable composition of the present invention comprises water, the amount of water relative to the total weight of the polymerizable composition is preferably 250 ppm to 10,000 ppm, more preferably 380 ppm to 5,000 ppm, particularly preferably 400 ppm to 2,000 ppm. Further, a kit of a two-part mixing curable resin composition may be prepared using, as a base resin, the above-mentioned polymerizable composition comprising water. Also when the one-part curable resin composition of the present invention comprises water, the water may be added or absorbed from water in the air. When the one-part curable resin composition of the present invention comprises water, the amount of water relative to the total weight of the one-part curable resin composition is preferably 250 ppm to 10,000 ppm , more preferably 380 ppm to 5,000 ppm, particularly preferably 400 ppm to 2,000 ppm. When the amount of water is too large, the water may be immiscible in the polymerizable composition and curing may unevenly occur. In order to achieve such a water content, it is preferred that the amount of water to be added relative to the total weight of the polymerizable composition or total weight of the one-part curable resin composition is 1 wt% or less relative to the total weight of the polymerizable composition or total weight of the one-part curable resin composition, respectively. In the present invention, when the water content is less than 250 ppm relative to the total amount of the polymerizable composition or one-part curable resin composition, substantially no water is deemed to be contained.

In general, when a certain kind of an adhesive is allowed to stand, the pot life may be disadvantageously shortened by reaction with water contained in the air. In particular, for example, a polymerizable composition comprising a cyanoacrylate compound must be carefully handled since this composition rapidly cures after contact with water.

On the other hand, the polymerizable composition of the present invention may contain water. That is, in an embodiment, the polymerizable composition of the present invention has an advantage in that the composition can be easily handled since the stability of the composition can be maintained for a long period of time even if water absorption occurs during the composition is allowed to stand. Further, depending on the kind of Component (b), generation of a gel-like precipitate, which may occur during the preparation of the polymerizable composition, may be suppressed by water contained in the polymerizable composition.

The polymerizable composition of the present invention comprises the above-mentioned Components (a) to (b) and, if necessary, the above-mentioned components such as stabilizer, filler and the like. The polymerizable composition of the present invention can be prepared by mixing these components. Apparatuses known in the art can be used for mixing. For example, mixing can be performed by an apparatus known in the art, such as a Henschel mixer or a roll mill. These components may be mixed simultaneously, or it may be such that a portion of these components are mixed first and the remainder is mixed later.

The polymerizable composition of the present invention may comprise components other than each of the above-mentioned components, such as a flame retardant, an ion trapper, an antifoaming agent, a leveling agent, a foam breaker and the like, as long as they do not impair the effectiveness of the present invention.

### [Polymerization initiator (Component (c))]

By combining the polymerizable composition of the present invention comprising the above-mentioned components with a polymerization initiator (Component (c)), a curable resin composition can be produced. The polymerization initiator is expected to contribute to the polymerization initiation reaction when the curable resin composition is cured by the Michael addition reaction. The polymerization initiator used in the present invention comprises a basic substance. The basic substance used as Component (c) in the present invention may be used individually or in combination. The present invention also provides a curable resin composition, particularly a one-part curable resin composition, comprising the polymerizable composition of the present invention and a polymerization initiator comprising at least one basic substance.

The basic substance used in the present invention typically comprises an organic base, an inorganic base or an organometallic material.

As examples of the organic base, there can be mentioned the amine compounds and the like described later. As examples of the inorganic base, there can be mentioned alkali metal hydroxides such as lithium hydroxide, sodium hydroxide, potassium hydroxide and cesium hydroxide; alkaline earth metal hydroxides such as calcium hydroxide; alkali or alkaline earth metal carbonates such as lithium carbonate, potassium carbonate and sodium carbonate; metal hydrogen carbonates such as potassium hydrogen carbonate and sodium hydrogen carbonate; and the like. As examples of the organometallic material, there can be mentioned organic alkali metal compounds such as butyllithium, t-butyllithium and phenyllithium, and organocopper reagents prepared therefrom; organic alkaline earth metal compounds such as methyl magnesium bromide, dimethyl magnesium and phenyl magnesium chloride, and organocopper reagents prepared therefrom; alkoxides such as sodium methoxide and t-butyl methoxide; and carboxylates such as sodium benzoate, and the like.

When the curable resin composition using the polymerizable composition of the present invention is used for an electronic material, if the composition comprises an inorganic base or an organometallic material, there is concern that this may have unintended impact on electrical characteristics in the electrical or electronic circuit in its vicinity. Therefore, the basic substance used in the present invention preferably does not comprise an alkali metal, an alkaline earth metal, a transition metal element or a halogen element. In another embodiment, the basic substance used in the present invention is non-ionic.

The basic substance used in the present invention is preferably an organic base, more preferably an amine compound. The above-mentioned amine compound is an organic compound having at least one of a primary amino group, a secondary amino group and a tertiary amino group within the molecule, and may have two or more amino groups of different classes within the same molecule at the same time.

As examples of the compound having a primary amino group, there can be mentioned, for example, methylamine, ethylamine, propylamine, butylamine, ethylenediamine, propylenediamine, hexamethylenediamine, diethylenetriamine, triethylenetetramine, ethanolamine, propanolamine, cyclohexylamine, isophoronediamine, aniline, toluidine, diaminodiphenylmethane, diaminodiphenylsulfone and the like.

As examples of the compound having a secondary amino group, there can be mentioned, for example, dimethylamine, diethylamine, dipropylamine, dibutylamine, dipentylamine, dihexylamine, dimethanolamine, diethanolamine, dipropanolamine, dicyclohexylamine, piperidine, piperidone, diphenylamine, phenylmethylamine, phenylethylamine and the like.

As examples of the compound having a tertiary amino group, there can be mentioned, for example, triethylamine, tributylamine, trihexylamine, triallylamine, 3-diethylaminopropylamine, dibutylaminopropylamine, tetramethylethylenediamine, tri-n-octylamine, dimethylaminopropylamine, N,N-dimethylethanolamine, triethanolamine, N,N-diethylethanolamine, N-methyl-N,N-diethanolamine, N,N-dibutylethanolamine, triphenylamine, 4-methyltriphenylamine, 4,4-dimethyltriphenylamine, diphenylethylamine, diphenylbenzylamine, N,N-diphenyl-p-anisidine, 1,1,3,3-tetramethylguanidine, N,N-dicyclohexylmethylamine, 1,4-diazabicyclo[2.2.2]octane, 2,6,10-trimethyl-2,6,10-triazaundecane, 1-benzylpiperidine, N,N-dimethylbenzylamine, N,N-dimethyldodecylamine, N-ethyl-N-methylbenzylamine, N,N-diethylbenzylamine and the like.

There is no particular limitation with respect to the compound having two or more amino groups of different classes within the same molecule at the same time. As examples of such compounds, there can be mentioned guanidine compounds, imidazole compounds and the like used as raw materials in the present embodiments. As examples of the guanidine compound, there can be mentioned dicyandiamide, methylguanidine, ethylguanidine, propylguanidine, butylguanidine, dimethylguanidine, trimethylguanidine, phenylguanidine, diphenylguanidine, tolylguanidine, 1,1,3,3-tetramethylguanidine and the like. As examples of the imidazole compound, there can be mentioned 2-ethyl-4-methylimidazole, 2-methylimidazole, 2-heptadecylimidazole, 2-phenyl-4,5-dihydroxymethylimidazole, 2-undecylimidazole, 2-phenyl-4-methyl-5-hydroxymethylimidazole, 2-phenyl-4-benzyl-5-hydroxymethylimidazole, 2,4-diamino-6-(2-methylimidazolyl-(1))-ethyl-s-triazine, 2,4-diamino-6-(2'-methylimidazolyl-(1'))-ethyl-s-triazine/isocyanuric acid adduct, 2-methylimidazole, 2-phenylimidazole, 2-phenyl-4-methylimidazole, 1-cyanoethyl-2-phenylimidazole, 1-cyanoethyl-2-methylimidazole-trimellitate, 1 -cyano ethyl-2-phenylimidazole-trimellitate, N-(2-methylimidazolyl-1-ethyl)-urea and N,N'-(2-methylimidazolyl-(1)-ethyl)-adipoyldiamide. However, the above-mentioned imidazole compounds are not limited to these compounds.

The above-mentioned amine compound preferably comprises a secondary or tertiary amino group. If the amino group contained in the amine compound is primary, possibility of suppression of the polymerization reaction by an active hydrogen generated from the amino group is increased. The above-mentioned amine compound more preferably comprises a tertiary amino group. In other words, the above-mentioned amine compound is more preferably a tertiary amine compound.

The above-mentioned amine compound is preferably free of an alkali metal, an alkaline earth metal, a transition metal element or a halogen element.

The above-mentioned amine compound is preferably free of a group having an active hydrogen, such as a hydroxy group and a sulfhydryl group.

In the curable resin composition using the polymerizable composition of the present invention, if the basic substance is in a solid form at the time of curing, the reaction proceeds on the surface of the basic substance, and the reaction does not extend throughout the entire composition, resulting in uneven curing. For this reason, it is preferred that at the time of curing, the basic substance is not in a solid form, i.e., in a liquid form or soluble in the polymerizable composition.

The molecular weight of the above-mentioned amine compound is preferably from 100 to 1,000, more preferably from 100 to 500, and even more preferably from 110 to 300. If the molecular weight of the amine compound is less than 100, its volatility is high, giving rise to concern that, among other things, it may affect components in the vicinity and cause the cured product to have variable physical properties. If the molecular weight of the amine compound exceeds 1,000, this may lead to, among other things, an increase in the viscosity of the amine compound and a decrease in the dispersibility of the amine compound in the composition.

In the present invention, the polymerization initiator may be used individually or in combination.

Specific examples of amine compounds preferable as the polymerization initiator include, but are not limited to, triethylamine, 1,4-diazabicyclo[2.2.2]octane, 1,1,3,3-tetramethylguanidine, N,N-dimethylbenzylamine, N-ethyl-N-methylbenzylamine, 2,6,10-trimethyl-2,6,10-triazaundecane, N,N-dimethyloctylamine, N,N-dimethyloctadecylamine and N,N-dimethyldodecylamine,N,N-diisopropylethylamine and N,N-dicyclohexylmethylamine.

In the present invention, the polymerization initiator may be such that it has been rendered inactivated by separation or latentization and can be activated by any stimulus, such as heat, light, mechanical shear or the like. More specifically, the polymerization initiator may be a latent curing catalyst such as a microcapsule, or those based on ion dissociation or an inclusion compound, and may be in a form that generates a base on exposure to heat, light, electromagnetic waves, ultrasonic waves, or physical shear. The present invention also provides a curable resin composition, particularly a one-part curable resin composition, comprising the polymerizable composition of the present invention and a polymerization initiator comprising at least one basic substance which is rendered latent.

Further, it is also possible to form a combination of the polymerizable composition of the present invention as a base resin with a curing agent comprising a polymerization initiator comprising at least one basic substance, the combination to be used as a kit of a two-part mixing curable resin composition (adhesive). The kit of a two-part mixing curable resin composition of the present invention can be cured by the contact of the above-mentioned base resin and curing agent.

In the present invention, the amount of the basic substance to be used is preferably 0.01 mol % to 30 mol %, more preferably 0.01 mol % to 10 mol %, based on the total amount (100 mol %) of Component (a) in the polymerizable composition. If the amount of the basic substance is less than 0.01 mol %, it results in inconsistent curing. Conversely, if the amount of the basic substance is more than 30 mol %, a large amount of the basic substance with no chemical bond formed with the resin matrix remains in the cured product, causing, among other things, deterioration in physical properties of the cured product as well as bleeding.

The above-mentioned basic substance may exhibit only a weak effect as Component (c), depending on its own structure, the structure of Component (a) used or the like. For example, N,N-diisopropylethylamine and N,N-dicyclohexylmethylamine have a weak effect as Component (c). This is considered to be due to steric hindrance. However, use of such a basic substance in combination with the polymerizable composition of the present invention practically improves the effect of the basic substance as Component (c) and is capable of providing curing with a satisfactory rate.

The polymerizable composition of the present invention, as well as the curable resin composition and kit using the polymerizable composition of the present invention, can be used as an adhesive or a sealing material. In particular, each of them can be used as a one-part resin composition, or a one-part adhesive or sealing material. Further, each of them can be used as a one-part resin composition in a solventless form, or a one-part adhesive or sealing material in a solventless form. Specifically, the above-mentioned polymerizable composition, the curable resin composition and kit are suitable as an adhesive or sealing material for electronic components. More specifically, the above-mentioned polymerizable composition, curable resin composition and kit can be used for adhesion and sealing of components for camera modules, and are particularly suitable for adhesion of sensor modules, such as image sensor modules. In the present invention, also provided are electronic components adhered using the above-mentioned polymerizable composition or the curable resin composition or kit using the polymerizable composition. Further, also provided are electronic components sealed using the above-mentioned polymerizable composition, curable resin composition or kit. Further, the above-mentioned polymerizable composition and curable resin composition can be used both as an insulating composition and as a conductive composition.

The present invention also provides a cured product obtained by curing, as described above, the polymerizable composition of the present invention or the curable resin composition or kit using the polymerizable composition of the present invention. Further, the present invention also provides a semiconductor device comprising this cured product.

For example, a jet dispenser, an air dispenser or the like can be used to supply the curable resin composition to the adherend surface. The above-mentioned curable resin composition can be cured at normal temperature without heating. The above-mentioned curable resin composition can also be cured by heating at a temperature of 25 to 80 °C, for example. The heating temperature is preferably 50 to 80 °C. The heating time is, for example, 0.01 to 4 hours.

### EXAMPLES

Hereinafter, Examples and Comparative Examples of the present invention will be explained. The present invention is not limited to the following Examples and Comparative Examples.

### [Preparation of resin compositions]

The raw materials for the composition used in the following Examples and Comparative Examples are as follows.

### 2-Methylene-1,3-dicarbonyl compound (Component (a)):

(a-1) DHMM (manufactured by Sirrus Inc.)
(a-2) DCHMM (manufactured by Sirrus Inc.)

The specific structures for the above-mentioned 2-methylene-1,3-dicarbonyl compounds are as shown by the chemical formulae in Table 1 below.

### [Table 1]

**Table 1**

| | | |
|---|---|---|
| (a-1) DHMM | Dihexyl methylene malonate | 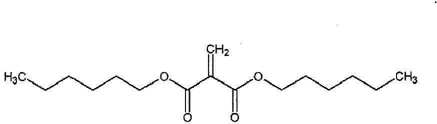 |
| (a-2) DCHMM | Dicyclohexyl methylene malonate | 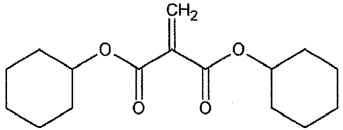 |

### Ionic compound (Component (b)):

(b-1) Trimethylpropylammonium bis(trifluoromethanesulfonyl)imide (Wako Pure Chemical Industries, Ltd., CAS registration number: 268536-05-6)
(b-2) 1-Butyl-1-methylpyrrolidinium bis(trifluoromethanesulfonyl)imide (Wako Pure Chemical Industries, Ltd., CAS registration number: 223437-11-4)
(b-3) 4-(2-Ethoxyethyl)-4-methylmorpholinium bis(trifluoromethanesulfonyl)imide (Wako Pure Chemical Industries, Ltd., CAS registration number: 663628-48-6)
(b-4) 1-Hexyl-4-methylpyridinium bis(trifluoromethanesulfonyl)imide (Wako Pure Chemical Industries, Ltd., CAS registration number: 870296-13-2)
(b-5) Tributyldodecylphosphonium bis(trifluoromethanesulfonyl)imide (Wako Pure Chemical Industries, Ltd., CAS registration number: 1002754-39-3)
(b-6) Tetrabutylammonium hexafluorophosphate (Wako Pure Chemical Industries, Ltd., CAS registration number: 3109-63-5)
(b-7) 1-Butyl-3-methylimidazolium hexafluorophosphate (Wako Pure Chemical Industries, Ltd., CAS registration number: 174501-64-5)
(b-8) Triethylsulfonium bis(trifluoromethanesulfonyl)imide (Sigma Aldrich, CAS registration number: 321746-49-0)
(b-9) Methyltrioctylammonium hexafluorophosphate (Wako Pure Chemical Industries, Ltd., CAS registration number: 569652-37-5)
(b-10) Methyltrioctylammonium trifluoromethanesulfonate (Kanto Chemical Co., Inc., CAS registration number: 121107-18-4)
(b-11) 1-Butyl-3-dodecylimidazolium bis(trifluoromethanesulfonyl)imide (Wako Pure Chemical Industries, Ltd.) CAS registration number: 1612842-42-8)
(b-12) Methyltrioctylammonium bis(trifluoromethanesulfonyl)imide (Wako Pure Chemical Industries, Ltd.) CAS registration number: 375395-33-8)

### Ionic compound (Component (b')):

(b'-1) Tetrabutylammonium acetate (Tokyo Chemical Industry Co., Ltd., CAS registration number: 10534-59-5)
(b'-2) Tributylmethylammonium dibutyl phosphate (Sigma Aldrich, CAS registration number: 922724-14-9)

Hereinafter, the anions contained in the compounds of Component (b) may be indicated by the following abbreviations.
- NTf₂⁻:: Bis(trifluoromethanesulfonyl)imide anion
- PF₆⁻:: Hexafluorophosphate anion
- Tf:: Trifluoromethanesulfonate anion

### Polymerization initiator (Component (c)):

(c-1) Triethylamine (Wako Pure Chemical Industries, Ltd., molecular weight: 101.19)
(c-2) N,N-Dicyclohexylmethylamine (Tokyo Chemical Industry Co., Ltd., molecular weight: 195.3)
(c-3) N,N-Dimethylbenzylamine (Wako Pure Chemical Industries, Ltd., molecular weight: 135.21)
(c-4) N,N-Diisopropylethylamine (Tokyo Chemical Industry Co., Ltd., molecular weight: 129.24)
(c-5) N,N-Dimethyloctadecylamine (Tokyo Chemical Industry Co., Ltd., molecular weight: 297.57)

### [Examples 1 to 10 and Comparative Examples 1 to 2]

With respect to each combination of the above-mentioned Component (a), Component (b) or (b') and Component (c) shown in Table 2, the storage stability and reaction promoting effect were evaluated as follows.

### ·Storage stability

To 10 mg of Component (b) or (b') in a sample tube made of polypropylene, 500 mg of Component (a) was added and both were fully mixed by shaking with a vortex mixer. The term until the obtained mixture practically lost its fluidity (gel time, unit: day) was measured at room temperature (22 °C). The results are shown in Table 2.

The expression "practically lost fluidity" means that the above-mentioned mixture charged in the above-mentioned sample tube reached a state in which no obvious change in shape is observed under gravity for 10 seconds after the above-mentioned sample tube containing the above-mentioned mixture is rapidly turned horizontal from a vertical position.

### . Reaction promoting effect

To about 3 mg of Component (b) or (b') taken in a sample tube made of polypropylene, Component (a) (in an amount that the ratio of the weight of Component (a) is 0.5 % of the sum of the weights (accurately measured) of these Components) was added and both were fully mixed by shaking with a vortex mixer. To the obtained mixture was added 0.05 equivalent of Component (c) based on Component (a). The time (unit: min) from the point of time of addition of Component (c) required for the obtained mixture to practically lose its fluidity was measured at room temperature (22 °C). This time is defined to be a "gel time (+)".

The expression "practically lose its fluidity" means that the above-mentioned mixture charged in the above-mentioned sample tube reached a state in which no obvious change in shape is observed under gravity for 10 seconds after the above-mentioned sample tube containing the above-mentioned mixture is rapidly turned horizontal from a vertical position.

Substantially the same procedure as the measurement of the gel time (+) was repeated except that no Component (b) or (b') was used, and the time (unit: min) from the point of time of addition of Component (c) required for the obtained mixture to practically lose its fluidity was measured at room temperature (22 °C). This time is defined to be a "gel time (-)".

A pair of the gel time (+) and the gel time (-) was measured on the same day using Component (a) of the same lot.

### [Table 2]

**Table 2**

| | Example 1 | Example 2 | Example 3 | Example 4 | Example 5 | Example 6 | Example 7 | Example 6 | Example 9 | Example 10 | Comparative Example 1 | Comparative Example 2 |
|---|---|---|---|---|---|---|---|---|---|---|---|---|
| Component (a) | (a-1) | (a-1) | (a-1) | (a-1) | (a-1) | (a-1) | (a-1) | (a-1) | (a-1) | (a-1) | (a-1) | (a-1) |
| Component (b) | (b-1) | (b-2) | (b-3) | (b-4) | (b-5) | (b-6) | (b-7) | (b-8) | (b-9) | (b-10) | - | - |
| Component (b') | - | - | - | - | - | - | - | - | - | - | (b-1) | (b'-2) |
| Component (c) | (c-1) | (c-1) | (c-1) | (c-1) | (c-1) | (c-1) | (c-1) | (c-1) | (c-1) | (c-1) | - | (c-1) |
| Storage stability (day) | >150 | >150 | >150 | >150 | >150 | >150 | >150 | >150 | >150 | 68 | <1 | <1 |
| Gel time (-) (min) | 16 | 19 | 19 | 14 | 19 | 16 | 14 | 17 | 17 | 17 | - | 19 |
| Gel time (+) (min) | 6 | 8 | 7 | 7 | 13 | 11 | 5 | 9 | 10 | 11 | - | 14 |

### [Example 1 to 14 and Comparative Examples 3 to 5]

With regard to each combination of the above-mentioned Components (a) to (c) shown in Table 3, the gel time was measured in substantially the same manner as in the measurement of the "gel time (+)" (when the amount of Component (b) is not 0 mg (Examples)) or "gel time (-)" (when the amount of Component (b) is 0 mg (Comparative Examples)) in the above-mentioned item "reaction promoting effect", except that the amount of each component was as shown in Table 3.

With regard to a pair of Examples and Comparative Examples using the same Component (a), each gel time was measured on the same day using Component (a) of the same lot.

With regard to each combination of the above-mentioned Components (a) and (b) shown in Table 3, the storage stability (unit: day) was measured in substantially the same manner as in the above-mentioned item "storage stability", except that the amount of each component was as shown in Table 3 (when the amount of Component (b) was 0 mg (Comparative Examples), Component (a) alone was charged in the sample tube).

### [Table 3]

**Table 3**

| | | Example 11 | Example 12 | Example 13 | Example 14 | Comparative Example 3 | Comparative Example 4 | Comparative Example 5 |
|---|---|---|---|---|---|---|---|---|
| Component (a) (mg) | (a-1) | 1000 | 1000 | - | 500 | 1000 | - | 500 |
| | (a-2) | - | - | 1000 | 500 | - | 1000 | 500 |
| Component (b) (mg) | (b-1) | 10 | 20 | 10 | 2 | - | - | - |
| Component (c) (mg) | (c-1) | - | - | 18 | - | - | 18 | - |
| | (c-2) | 17 | 17 | - | - | 17 | - | - |
| | (c-3) | - | - | - | 9 | - | - | 9 |
| Gel time (min) | | 95 | 56 | 19 | 8 | >1800 | 61 | 11 |
| Storage stability (day) | | >150 | >150 | >150 | >150 | >150 | >150 | >150 |

### (Discussion of results)

Examples 1 to 14 show that by the use of an ionic compound with the anion NTf2, PF6, or Tf, the resultant mixture of this compound and Component (a) show high storage stability, and that this compound promotes polymerization of Component (a) initiated by Component (c). Each of Examples 1 to 9 and 11 to 14 exhibited particularly excellent storage stability of more than 150 days. The above matters show that such an ionic compound can be suitably used as Component (b) in the present invention.

In Comparative Examples 1, immediate gelation was caused just by mixing Component (b'-1) with Component (a), and measurement of the gel time with addition of Component (c) could not be carried out. Comparative Examples 1 to 2 show that by the use of an ionic compound with the anion being a carboxylate anion or phosphate anion, the resultant mixture of this compound and Component (a) shows low storage stability. This seems to be because the above-mentioned anion has nucleophilicity sufficient for reacting with Component (a) and functions itself as a polymerization initiator for Component (a). An ionic compound containing such an anion cannot be used as Component (b) in the present invention.

Comparative Example 3 is an example with addition of no Component (b) to be compared with Examples 11 and 12.

Comparative Example 4 is an example with addition of no Component (b) to be compared with Example 13.

Comparative Example 5 is an example with addition of no Component (b) to be compared with Examples 14.

### [Examples 15 to 21]

Further improvement in storage stability was investigated for the polymerizable composition of the present invention comprising water.

The components and amount of each component shown in Table 4 were used. To 20 mg of Component (b) in a container made of polypropylene were added a predetermined amount of pure water (except for Examples 15 and 18) and then 1,000 mg of Component (a), and they were fully mixed by shaking with a vortex mixer to thereby obtain a polymerizable composition. The water content value of the composition of Examples 15 higher than that of Examples 18 is due to moisture absorption.

Immediately after a lapse of 1 hour from the completion of mixing, presence or absence of a gel-like precipitate in the polymerizable composition was visually determined and, at this point of time, the water content of the polymerizable composition (when the gel-like precipitate was generated, the supernatant of the polymerizable composition) was measured using a Karl Fischer moisture meter (coulometric titration method) MKC-520 manufactured by Kyoto Electronics Industry Co., Ltd..

With regard to each mixture obtained by adding 6.9 µL of (c-1) to 300 µL of each of the above-mentioned polymerizable compositions (when the gel-like precipitate was formed, the supernatant of the above-mentioned polymerizable composition), the gel time was measured in substantially the same manner as in the measurement of the above-mentioned "gel time (+)".

Further, with regard to each combination of the above-mentioned Component (a) and (b) shown in Table 4, the storage stability (unit: day) was measured in substantially the same manner as in the description of the above-mentioned item "storage stability", except that the amount of each component was as shown in Table 4.

### [Table 4]

**Table 4**

| | | Example 15 | Example 16 | Example 17 | Example 18 | Example 19 | Example 20 | Example 21 |
|---|---|---|---|---|---|---|---|---|
| Component (a) (mg) | (a-1) | 1000 | 1000 | 1000 | 1000 | 1000 | 1000 | 1000 |
| Component (b) (mg) | (b-11) | 20 | 20 | 20 | - | - | - | - |
| | (b-12) | - | - | - | 20 | 20 | 20 | 20 |
| Water content of composition (ppm)* | | 359 | 451 | 1073 | 237 | 346 | 549 | 750 |
| Presence or absence of gel-like precipitate* | | Present | Absent | Absent | Present | Present | Absent | Absent |
| Storage stability (day) | | >10 | >10 | >10 | >10 | >10 | >10 | >10 |
| Gel time (min) | | 3 | 2 | 2 | 2 | 2 | 2 | 2 |

| | | | | | | | | |
|---|---|---|---|---|---|---|---|---|
| *: State after 1 hour from the preparation of the curable resin composition | | | | | | | | |

### (Discussion of results)

When Component (b) is contancted with Component (a), a gel-like precipitate may be formed. In fact, (b-11) and (b-12) used in this exoeriment brought formation of a gel-like precipitate (Examples 15, 18 amd 19). The cause of formation of such a gel- like precipitate has not been clarified. However, a minute amount of impurity contained in commercially available Component (b) might have functioned as a polymerization initiator of Component (a).

On the other hand, when a sufficient amount of water is present in the polymerizable composition, formation of such a gel-like precipitate is suppressed. The amount of water to be added may vary depending on the amount of water originally contained in the starting material itself or the amount of water disappeared by the reaction, but formation of the gel-like precipitate can be suppressed (Examples 16, 17, 20 and 21) by water contained in the polymerizable composition in an amount of 400 ppm or more.

Incidentally, even in the polymerizable composition in which a gel-like precipitate was formed, curability of the supernatant (the portion in a liquid form) was not impaired. In fact, the curability of the supernatant was the same as that of the polymerizable composition in which formation of the gel-like precipitate was sufficiently suppressed. Further, the amount of the gel-like precipitate was visually as small as several vol% or so. Therefore, it can be expected that the polymerizable composition containing the gel-like precipitate can be used for producing the curable resin composition in substantially the same manner as in the polymerizable composition in which formation of the gel-like precipitate is sufficiently suppressed. However, from the viewpoint of industrial applicability, it is desirable to suppress generation of the gel-like precipitate.

### [Reference Examples 1 to 5 and Examples 22 to 25]

### Application of a two-part mixing curable resin composition to kit

With regard to each combination of the above-mentioned Components (a) to (c) and water (H₂O) shown in Table 5, the composition was prepared by the following manner with the amount of each component as shown in Table 5.

That is, with regard to the components described for each of Examples 22 and 23 and Reference Examples 1 and 3, Component (b), pure water and Component (a) were weighed out, transferred into a container made of polypropylene in this order and fully mixed by shaking with a vortex mixer to thereby obtain a composition.

Example 24 is an example in which a composition is prepared by mixing the composition of Example 22 with that of Reference Example 3 at a ratio of 1 : 1.

Example 25 is an example in which a composition is prepared by mixing the composition of Example 23 with that of Reference Example 3 at a ratio of 1 : 1.

Reference Example 4 is an example in which a composition is prepared by mixing the composition of Reference Example 1 with that of Reference Example 3 at a ratio of 1 : 1.

Reference Example 5 is an example in which a composition is prepared by mixing the composition of Reference Example 2 with that of Reference Example 3 at a ratio of 1 : 1.

The time (unit: min) from the point of time of completion of addition and mixing of each component required for the obtained mixture to practically lose its fluidity was measured at room temperature (22 °C). This time is defined to be a "gel time".

The expression "practically lose its fluidity" means that the above-mentioned mixture charged in the above-mentioned sample tube reached a state in which no obvious change in shape is observed under gravity for 10 seconds after the above-mentioned sample tube containing the above-mentioned mixture is rapidly turned horizontal from a vertical position.

Each gel time described in Table 5 was measured on the same day using Component (a) of the same lot.

### [Table 5]

**Table 5**

| | | Example 22 | Example 23 | Reference Example 1 | Reference Example 2 | Reference Example 3 | Example 24 | Example 25 | Reference Example 4 | Reference Example 5 |
|---|---|---|---|---|---|---|---|---|---|---|
| Component (a) (mg) | (a-1) | 1000 | 1000 | 1000 | 1000 | 1000 | 1000 | 1000 | 1000 | 1000 |
| Component (b) (mg) | (b-1) | 20 | 20 | - | - | - | 10 | 10 | - | - |
| Component (c) (mg) | (c-4) | - | - | - | - | 22 | 11 | 11 | 11 | 11 |
| H₂O (mg) | | 1 | - | 1 | - | - | 0.5 | - | 0.5 | - |
| Gel time (min) | | * | * | * | * | 240 | 35 | 45 | 300 | 300 |

| | | | | | | | | | | |
|---|---|---|---|---|---|---|---|---|---|---|
| *: Over 3 weeks | | | | | | | | | | |

### (Discussion of results)

Component (c) used in the composition shown in Table 5, i.e., (c-4), exhibits relatively weak reactivity when it is individually used with Component (a). Therefore, the storage stability of the composition of Reference Example 3 (consisting of Components (a) and (c)) is promising.

The composition of each of Examples 22 to 23 and Reference Examples 1 to 2 had excellent storage stability since no Component (c), which is an initiator, is contained.

On the other hand, the composition of each of Examples 24 and 25 was rapidly cured. These compositions correspond to the mixtures obtained by mixing, with the same volume of the composition of Reference Example 3, the composition of Example 22 and composition of Example 23, respectively.

That is, the compositions of Examples 22 to 23 and the composition of Reference Example 3 each have good storage stability, but the mixture obtained by mixing these rapidly cures. Accordingly, the combination of these compositions can be suitably used as a kit of a two-part mixing curable resin composition.

The composition of Examples 24 having a composition in which water was added to the composition of Examples 25 cured more rapidly than the composition of Examples 25.

The compositions of Reference Examples 4 and 5, which correspond to the mixtures obtained by mixing, with the same volume of the composition of Reference Example 3, the compositions of Reference Examples 1 and 2 containing no Component (b), respectively, required a long time for curing.

### [Examples 26 to 29 and Comparative Examples 6 to 9]

The influence of acidic impurities (contaminants) on the polymerizable composition of the present invention was investigated.

With regard to each combination of the above-mentioned Components (a) to (c) and trifluoroacetic acid (TFA) shown in Table 6, the gel time was measured in substantially same manner as in the measurement of the "gel time (+)" (when the amount of Component (b) is not 0 mg (Examples)) or "gel time (-)" (when the amount of Component (b) is 0 mg (Comparative Examples)) in the above-mentioned item "reaction promoting effect", except that the amount of each component was as shown in Table 6.

In these experiments, the polymerizable composition containing TFA, that is, the mixture of Components (a) and (b) and TFA, was prepared as follows.

1 mg of TFA was dissolved in 1,000 mg of (a-1), and the obtained solution was appropriately diluted with (a-1) to thereby prepare three (a-1) solutions containing 25, 50 and 100 ppm of TFA, respectively. These three solutions were each divided into two equal parts, in one of which (b-1) was dissolved so that the concentration was 1 wt%.

Measurement of the gel time was started from the point of time at which Component (c) was added to these TFA-containing mixtures.

### [Table 6]

**Table 6**

| | | Example 26 | Example 27 | Example 28 | Example 29 | Comparative Example 6 | Comparative Example 7 | Comparative Example 8 | Comparative Example 9 |
|---|---|---|---|---|---|---|---|---|---|
| Component (a)^{*1} | (a-1) | 99 | 99 | 99 | 99 | 100 | 100 | 100 | 100 |
| Component (b)^{*2} | (b-1) | 1 | 1 | 1 | 1 | 0 | 0 | 0 | 0 |
| Component (c)^{*3} | (c-1) | 0.05 | 0.05 | 0.05 | 0.05 | 0.05 | 0.05 | 0.05 | 0.05 |
| TFA ^{*4} | | 0 | 25 | 50 | 100 | 0 | 25 | 50 | 100 |
| Gel time (min) | | 9 | 11 | 11 | 12 | 23 | 29 | 34 | 49 |

| | | | | | | | | | |
|---|---|---|---|---|---|---|---|---|---|
| *1: % by mass relative to the total mass of Component (a) and Component (b) (when the amount of TFA is not 0, the mass of Component (a) is the total mass of Component (a) and TFA) *2: % by mass relative to the total mass of Component (a) and Component (b) (when the amount of TFA is not 0, the mass of Component (a) is the total mass of Component (a) and TFA) *3: Number of equivalent relative to Component (a) (a ratio of the molar number of Component (c) relative to the molar number of Component (a)) *4: ppm by mass relative to the total mass of Component (a) and TFA | | | | | | | | | |

### (Discussion of results)

The anionic polymerization of Component (a) is susceptible to a minute amount of impurities. For example, a strong acid, such as TFA, may be added to Component (a) for increasing storage stability. This strong acid may affect the gel time of Component (a). In fact, the gel time of (a-1) became long, depending on the amount of TFA added to (a-1) (Comparative Examples 6 to 9).

On the other hand, when a fixed amount of Component (b) was added to (a-1), the gel time of (a-1) was greatly shortened. Further, the gel time of (a-1) substantially converged to a constant value (Examples 26 to 29).

As apparent from the above, the polymerizable composition of the present invention can exhibit an excellent curing rate since Component (b) is contained, even when a stabilizer is contained. Further, the above-mentioned acceleration of curing brings an advantage of the gel time with less variability, despite potential variation in amount of the stabilizer or type and amount of other impurities, which is/are difficult to accurately control.

### ·Preparation of latent polymerization initiator (latent amine (c-6))

A latent amine was prepared in accordance with the method described in JP 2015-512460A (Sirrus Incorporated).

Wax (polyethylene glycol, molecular weight 8,000; available from MP Biomedicals, LLC) and (c-5) (5% by weight based on the total weight of both components) were mixed in a molten state, and the resultant mixture was allowed to cool under stirring to thereby obtain a powder. The resultant powder was further subjected to coating with the same weight of the above-mentioned wax in a molten state to thereby obtain a coated powder, which was used as latent amine (c-6). The weight of (c-5) contained in latent amine (c-6) was about 2.5%.

### [Examples 30 to 31 and Comparative Examples 10 to 11]

With regard to each combination of the above-mentioned Components (a) to (c) shown in Table 7, the gel time was measured in substantially same manner as in the measurement of the "gel time (+)" (when the amount of Component (b) is not 0 mg (i.e., Examples)) or "gel time (-)" (when the amount of Component (b) is 0 mg (i.e., Comparative Examples)) in the above-mentioned item "reaction promoting effect", except that:
- the amount of each component was as shown in Table 7, and
- with regard to Example 30 and Comparative Example 10, the mixture obtained by addition of Component (c) (used as the above-mentioned latent amine (c-6)) was subjected to an activation step, and the time (unit: min) from the point of time of completion of the activation step required for the above-mentioned mixture to practically lose its fluidity was measured while the mixture being allowed to cool at room temperature (22 °C).

The activation step was a step of heating the above-mentioned mixture by applying hot air from a hair dryer to the reaction vessel until complete melting of the latent amine was visually observed (completion of the activation step).

Each gel time was measured on the same day using Component (a) of the same lot.

### [Table 7]

**Table 7**

| | | Example 30 | Example 31 | Comparative Example 10 | Comparative Example 11 |
|---|---|---|---|---|---|
| Component (a) (mg) | (a-1) | 500 | 500 | 500 | 500 |
| Component (b) (mg) | (b-1) | 2.5 | 2.5 | - | - |
| Component (c) (mg)^{*} | (c-6) | 10 | 10 | 10 | 10 |
| Activation step | | Present | Absent | Present | Absent |
| Gel time (min) | | 16 | >360 | 39 | >360 |

| | | | | | |
|---|---|---|---|---|---|
| "Weight of (c-5) in latent amine (c-6) | | | | | |

### (Discussion of results)

It has been shown that the timing of curing can be controlled by using the latent polymerization initiator (Examples 30 to 31).

It has also been shown that Component (b) does not affect control of the effect of the polymerization initiator by latentization (Example 31 and Comparative Example 11) and promotes curing of Component (a) even in the presence of the component used for latentization (wax) (Examples 30, Comparative Example 10).

### INDUSTRIAL APPLICABILITY

The polymerizable composition of the present invention is capable of promoting anionic polymerization of a 2-methylene-1,3-dicarbonyl compound without impairing storage stability, and useful for producing a curable resin composition.

## Claims

1. A polymerizable composition comprising:
(a) at least one 2-methylene-1,3-dicarbonyl compound each having at least one structural unit represented by formula (I) below: 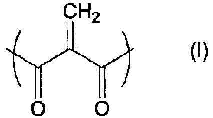 and
(b) at least one ionic compound which does not substantially react with the compound (a), the ionic compound comprising:
an anion selected from the group consisting of a bissulfonylimide anion, hexafluorophosphate anion and a sulfonate anion; and
an onium cation, and
which polymerizable composition polymerizes when contacted with a polymerization initiator comprising at least one basic substance.

2. . The polymerizable composition according to claim 1, wherein the onium cation of the ionic compound (b) is at least one member selected from the group consisting of an ammonium cation, a phosphonium cation and a sulfonium cation.

3. . The polymerizable composition according to claim 1 or 2, wherein the molecular weight of the 2-methylene-1,3-dicarbonyl compound, determined according to the method mentioned in the specification, is 180 or more and 10,000 or less.

4. . The polymerizable composition according to any one of claims 1 to 3, which comprises 250 ppm to 10,000 ppm of water.

5. . A one-part curable resin composition which comprises the polymerizable composition according to any one of claims 1 to 4 and a polymerization initiator comprising at least one basic substance which is rendered latent.

6. . The one-part curable resin composition according to claim 5, which comprises 250 ppm to 10,000 ppm of water.

7. . A kit of a two-part mixing curable resin composition, which comprises:
(A) a base resin comprising the polymerizable composition according to any one of claims 1 to 4; and
(B) a curing agent comprising the following (c):
(c) a polymerization initiator comprising at least one basic substance.

8. . Use of the polymerizable composition according to any one of claims 1 to 4, the one-part curable resin composition according to claim 5 or 6 or the kit according to claim 7, for the production of electronic components.

9. . An adhesive or sealing material for electronic components, which comprises the polymerizable composition according to any one of claims 1 to 4, the one-part curable resin composition according to claim 5 or 6, or the kit according to claim 7.

10. . A cured product obtained by curing the polymerizable composition according to any one of claims 1 to 4, the one-part curable resin composition according to claim 5 or 6, the kit according to claim 7, or the adhesive or sealing material according to claim 9.

11. . A semiconductor device which comprises the cured product according to claim 10.

## Patentansprüche

1. Polymerisierbare Zusammensetzung, umfassend:
(a) mindestens eine 2-Methylen-1,3-dicarbonyl-Verbindung mit jeweils mindestens einer Struktureinheit, dargestellt durch die folgende Formel (I): 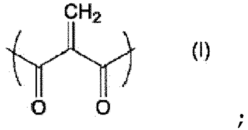 und
(b) mindestens eine ionische Verbindung, die im Wesentlichen nicht mit der Verbindung (a) reagiert, wobei die ionische Verbindung umfasst:
ein Anion, ausgewählt aus der Gruppe, bestehend aus einem Bissulfonylimid-Anion, einem Hexafluorphosphat-Anion und einem Sulfonat-Anion; und
ein Onium-Kation, und
wobei die polymerisierbare Zusammensetzung polymerisiert, wenn sie mit einem Polymerisationsinitiator in Kontakt gebracht wird, der mindestens eine basische Substanz umfasst.

2. Polymerisierbare Zusammensetzung gemäß Anspruch 1, wobei das Onium-Kation der ionischen Verbindung (b) mindestens ein Mitglied ist, das aus der Gruppe, bestehend aus einem Ammonium-Kation, einem Phosphonium-Kation und einem Sulfonium-Kation, ausgewählt ist.

3. Polymerisierbare Zusammensetzung gemäß Anspruch 1 oder 2, wobei das Molekulargewicht der 2-Methylen-1,3-dicarbonyl-Verbindung, bestimmt gemäß dem in der Beschreibung erwähnten Verfahren, 180 oder mehr und 10.000 oder weniger beträgt.

4. Polymerisierbare Zusammensetzung gemäß einem der Ansprüche 1 bis 3, umfassend 250 ppm bis 10.000 ppm Wasser.

5. Einteilige härtbare Harzzusammensetzung, umfassend die polymerisierbare Zusammensetzung gemäß einem der Ansprüche 1 bis 4 und einen Polymerisationsinitiator, der mindestens eine latent gemachte basische Substanz umfasst.

6. Einteilige härtbare Harzzusammensetzung gemäß Anspruch 5, umfassend 250 ppm bis 10.000 ppm Wasser.

7. Kit einer zweiteiligen mischbaren härtbaren Harzzusammensetzung, umfassend:
(A) ein Basisharz, umfassend die polymerisierbare Zusammensetzung gemäß einem der Ansprüche 1 bis 4; und
(B) ein Härtungsmittel, umfassend folgendes (c):
(c) einen Polymerisationsinitiator, umfassend mindestens eine basische Substanz.

8. Verwendung der polymerisierbare Zusammensetzung gemäß einem der Ansprüche 1 bis 4, der einteiligen härtbaren Harzzusammensetzung gemäß Anspruch 5 oder 6 oder des Kits gemäß Anspruch 7 zur Herstellung von elektronischen Komponenten.

9. Klebstoff oder Dichtungsmaterial für elektronische Komponenten, umfassend die polymerisierbare Zusammensetzung gemäß einem der Ansprüche 1 bis 4, die einteilige härtbare Harzzusammensetzung gemäß Anspruch 5 oder 6 oder das Kit gemäß Anspruch 7.

10. Gehärtetes Produkt, erhalten durch Härten der polymerisierbaren Zusammensetzung gemäß einem der Ansprüche 1 bis 4, der einteiligen härtbaren Harzzusammensetzung gemäß Anspruch 5 oder 6, des Kits gemäß Anspruch 7 oder des Klebstoffs oder Dichtungsmaterials gemäß Anspruch 9.

11. Halbleitervorrichtung, umfassend das gehärtete Produkt gemäß Anspruch 10.

## Revendications

1. Composition polymérisable comprenant :
(a) au moins un composé de 2-méthylène-1,3-dicarbonyle ayant chacun au moins un motif de structure représenté par la formule (I) ci-dessous : 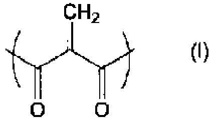 et
(b) au moins un composé ionique qui ne réagit sensiblement pas avec le composé (a), le composé ionique comprenant :
un anion sélectionné dans le groupe consistant en un anion bissulfonylimide, un anion hexafluorophosphate et un anion sulfonate ; et
un cation onium, et
laquelle composition polymérisable se polymérise lorsqu'elle est mise en contact avec un initiateur de polymérisation comprenant au moins une substance basique.

2. Composition polymérisable selon la revendication 1, dans laquelle le cation onium du composé ionique (b) est au moins un élément sélectionné dans le groupe consistant en un cation ammonium, un cation phosphonium et un cation sulfonium.

3. Composition polymérisable selon la revendication 1 ou la revendication 2, dans laquelle le poids moléculaire du composé de 2-méthylène-1,3-dicarbonyle, déterminé selon le procédé mentionné dans la description, est de 180 ou plus et de 10 000 ou moins.

4. Composition polymérisable selon l'une quelconque des revendications 1 à 3, qui comprend 250 ppm à 10 000 ppm d'eau.

5. Composition de résine durcissable en une partie qui comprend la composition polymérisable selon l'une quelconque des revendications 1 à 4 et un initiateur de polymérisation comprenant au moins une substance basique qui est rendue latente.

6. Composition de résine durcissable en une partie selon la revendication 5, qui comprend 250 ppm à 10 000 ppm d'eau.

7. Kit d'une composition de résine durcissable par mélange en deux parties, qui comprend :
(A) une résine de base comprenant la composition polymérisable selon l'une quelconque des revendications 1 à 4 ; et
(B) un agent de durcissement comprenant le (c) suivant :
(c) un initiateur de polymérisation comprenant au moins une substance basique.

8. Utilisation de la composition polymérisable selon l'une quelconque des revendications 1 à 4, la composition de résine durcissable en une partie selon la revendication 5 ou la revendication 6 ou le kit selon la revendication 7, pour la production de composants électroniques.

9. Matériau adhésif ou d'étanchéité pour composants électroniques, qui comprend la composition polymérisable selon l'une quelconque des revendications 1 à 4, la composition de résine durcissable en une partie selon la revendication 5 ou la revendication 6, ou le kit selon la revendication 7.

10. Produit durci obtenu en durcissant la composition polymérisable selon l'une quelconque des revendications 1 à 4, la composition de résine durcissable en une partie selon la revendication 5 ou la revendication 6, le kit selon la revendication 7, ou le matériau adhésif ou d'étanchéité selon la revendication 9.

11. Dispositif à semi-conducteur qui comprend le produit durci selon la revendication 10.
